Europäisches Patentamt

European Patent Office

Office européen des brevets

(19)

(11) Publication number: 0 347 333 A2

# (12) EUROPEAN PATENT APPLICATION

(21) Application number: 89401716.9

(22) Date of filing: 16.06.89

(51) Int. Cl.⁴: G 11 C 7/00
G 11 C 11/40

(30) Priority: 17.06.88 JP 150849/88

(43) Date of publication of application:
20.12.89 Bulletin 89/51

(84) Designated Contracting States: DE FR GB

(71) Applicant: FUJITSU LIMITED
1015, Kamikodanaka Nakahara-ku
Kawasaki-shi Kanagawa 211 (JP)

FUJITSU VLSI LIMITED
1884-2, Kozoji-cho 2-chome
Kasugai-shi Aichi 487 (JP)

(72) Inventor: Kimoto, Masayoshi
2-5-2-102, Suge Tama-ku
Kawasaki-shi Kanagawa 214 (JP)

Kohno, Kazuyuki
221, Higashikata
Kuwana-shi Mie 511 (JP)

(74) Representative: Joly, Jean-Jacques et al
CABINET BEAU DE LOMENIE 55, rue d'Amsterdam
F-75008 Paris (FR)

(54) Semiconductor device having memory with ECL gate array.

(57) A semiconductor device in a single chip comprises a memory (20) having a plurality of memory cells, and an emitter coupled logic gate array (21) for carrying out a predetermined logic operation on a data output from one of the memory cells of the memory and for outputting an output signal having a first amplitude. The memory includes a circuit (25₁-25₄) for outputting as the data output a positive phase signal (+DO) and a negative phase signal (-DO) respectively having a second amplitude smaller than the first amplitude.

FIG. 3

Description

# SEMICONDUCTOR DEVICE HAVING MEMORY WITH ECL GATE ARRAY

## BACKGROUND OF THE INVENTION

The present invention generally relates to semiconductor devices, and more particularly to a semiconductor device having a memory with emitter coupled logic (ECL) gate array such as a so-called random access memory (RAM) with ECL gate array.

A bipolar RAM is used as a cashe memory and the like of a large scale computer and plays an important role in further improving a high performance system. On the other hand, a gate array which constitutes a desired circuit by a customized large scale integrated circuit (LSI) is recently receiving much attention from the point of view of the relatively low production cost since a system desired by a user can be formed by merely modifying a final stage of a wafer process. A bipolar RAM having a built-in ECL gate array is integrated within a single chip as the so-called RAM with ECL gate array.

In the RAM with ECL gate array, various required logic operations are carried out in the ECL gate array by use of a data output of the RAM. In this case, there is a demand to transmit at a high speed the data output of the RAM to the ECL gate array which constitutes a logic part.

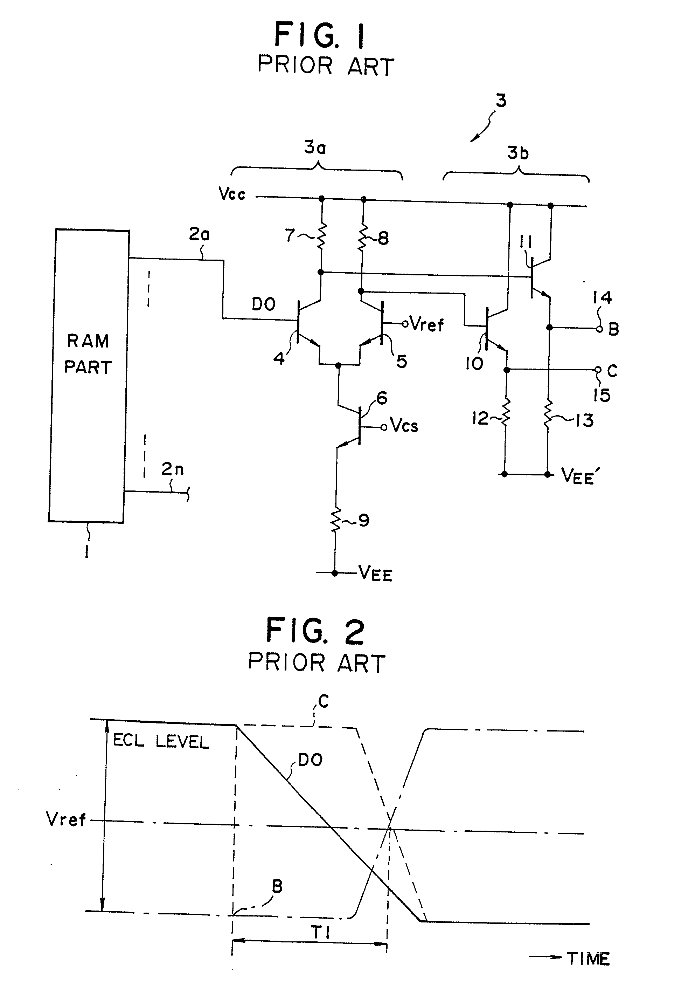

FIG.1 shows an example of a conventional RAM with ECL gate array. FIG.1 is a circuit diagram of a portion included within a single chip. A RAM part 1 includes memory cells and a read and write circuit. Outputs 2a through 2n of the RAM part 1 are connected to corresponding ECL circuit 3 which constitutes a logic part. Only the data with a positive phase (or negative phase) is output from the RAM part 1. The ECL circuit 3 is made up of a differential logic part 3a and an emitter follower output part 3b. The differential logic part 3a has transistors 4 through 6 and resistors 7 through 9, while the emitter follower output part 3b has transistors 10 and 11 and resistors 12 and 13. Power source voltages $V_{CC}$, $V_{EE}$ and $V_{EE}'$ are respectively set to $V_{CC} = 0$ V (GND), $V_{EE} = -3.6$ V and $V_{EE}' = -2$ V. In addition, a reference voltage $V_{ref}$ is set to $V_{ref} = -1.32$V and a voltage $V_{CS}$ applied to a base of the transistor 6 which is used as a current source is set to $V_{CS} = -2.4$ V.

An operation timing of the ECL circuit 3 is as shown in FIG.2 where DO denotes a signal (data output) on the line 2a, and B and C respectively denote signals at output terminals 14 and 15. The data output of the RAM part 1 varies within a range such that a high level is -0.9 V and a low level is -1.5 V to -1.6 V. An ECL level shown in FIG.2 refers to an amplitude of the signal level output from the ECL circuit 3. For example, in a case where the signal DO changes from a high level to a low level, the transistor 4 turns OFF and the transistor 5 turns ON when the level of the signal DO becomes smaller than the reference voltage $V_{ref}$. As a result, a collector voltage of the transistor 5 decreases, thereby turning the transistor 10 OFF and changing the signal C from a high level to a low level. In this state, the signal B changes from a low level to a high level as the signal C changes from the high level to the low level. Therefore, there is a delay time T1 from the beginning of change of the signal DO to the change of the output signals B and C of the logic circuit as shown in FIG.2.

That is, in the conventional RAM with ECL gate array, the data output from the RAM part 1 is output with a single phase (that is, positive or negative phase) and a switching takes place in the ECL circuit 3 responsive to a change in the single phase data output of the RAM part 1. For this reason, there is a delay in the rise and fall of the data output of the RAM part 1 and it takes a relatively long time for the switching to take place in the ECL circuit 3. As a result, there is a problem in that a data processing speed of the semiconductor device as a whole is not sufficiently high.

## SUMMARY OF THE INVENTION

Accordingly, it is a general object of the present invention to provide a novel and useful semiconductor device in which the problems described above are eliminated.

Another and more specific object of the present invention is to provide a semiconductor device in a single chip comprising a memory having a plurality of memory cells, and an emitter coupled logic gate array for carrying out a predetermined logic operation on a data output from one of the memory cells of the memory and for outputting an output signal having a first amplitude, where the memory includes means for outputting as the data output a positive phase signal and a negative phase signal respectively having a second amplitude smaller than the first amplitude. According to the semiconductor device of the present invention, the amplitude of the data output of the memory is small, and a change in the data output is directly transmitted to the emitter coupled logic gate array as a differential input. Hence, it is possible to reduce the switching time in the emitter coupled logic gate array and carry out a data processing at a high speed.

Other objects and further features of the present invention will be apparent from the following detailed description when read in conjunction with the accompanying drawings.

## BRIEF DESCRIPTION OF THE DRAWINGS

FIG.1 is a circuit diagram showing a portion of an example of a conventional RAM with ECL gate array;

FIG.2 is a timing chart for explaining an operation of an ECL circuit shown in FIG.1;

FIG.3 is a system block diagram showing an embodiment of a semiconductor device according to the present invention;

FIG.4 is a circuit diagram showing an essential part of the semiconductor device shown in FIG.3;

FIG.5 is a timing chart for explaining read and write operations carried out in the circuit shown in FIG.4;

FIG.6 is a circuit diagram showing another essential part of the semiconductor device shown in FIG.3; and

FIG.7 is a timing chart for explaining an operation of the embodiment.

## DESCRIPTION OF THE PREFERRED EMBODIMENTS

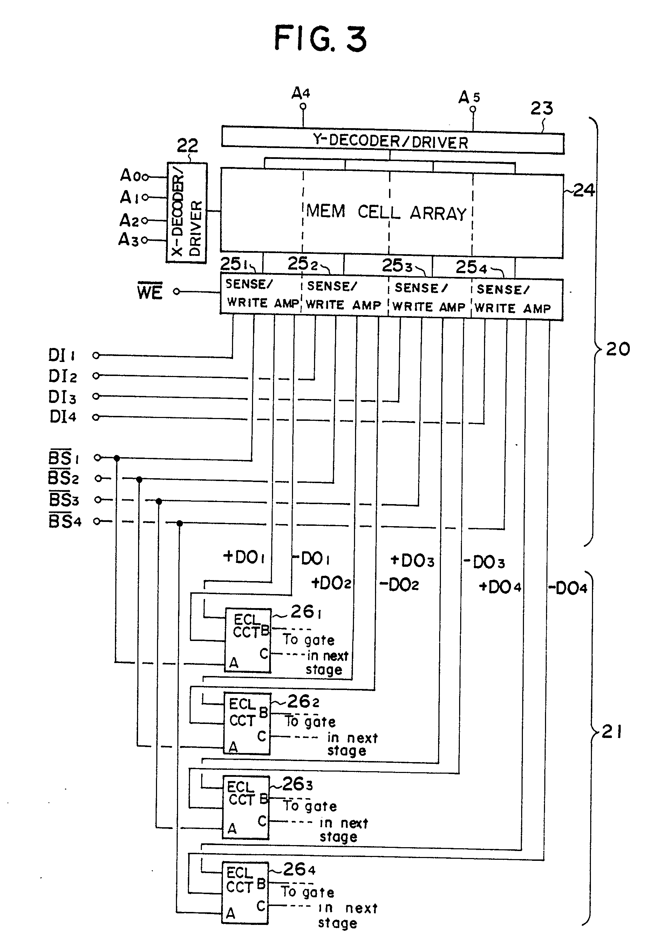

FIG.3 generally shows an embodiment of a semiconductor device according to the present invention. In this embodiment, the semiconductor device is a RAM with ECL gate array, and FIG.3 shows a structure within a chip.

The RAM with ECL gate array shown in FIG.3 generally has a RAM part 20 and an ECL gate array part 21. The RAM part 20 includes an X-decoder/driver 22 for decoding and driving a predetermined word line based on address data A0 through A3 in an X-direction, a Y-decoder/driver 23 for decoding and driving a predetermined bit line based on address data A4 and A5 in a Y-direction, a bipolar static memory cell array 24 for storing data of predetermined bits, and sense/write amplifiers $25_1$ through $25_4$ for controlling a write operation with respect to the memory cell array 24 based on a write enable signal $\overline{WE}$ and for reading data from the memory cell array 24. An input data $DIi$ and a control signal $\overline{BSi}$ are supplied to a sense/write amplifier $25_i$, where $i = 1, 2, 3$ and $4$. The sense/write amplifier $25_i$ outputs a positive phase signal $+DOi$ and a negative phase signal $-DOi$ with respect to one data, where $i = 1, 2, 3$ and $4$. For example, the positive phase signals $+DO1$ through $+DO4$ and the negative phase signals $-DO1$ through $-DO4$ vary within a range such that a high level is approximately $-1.2$ V and a low level is approximately $-1.6$ V. In other words, an amplitude of the binary signals $+DO1$ through $+DO4$ and $-DO1$ through $-DO4$ is reduced to approximately one-half the ECL level of the conventional case described before in conjunction with FIG.2. The ECL level is the amplitude of the signal output from the ECL gate array part 21 in this case.

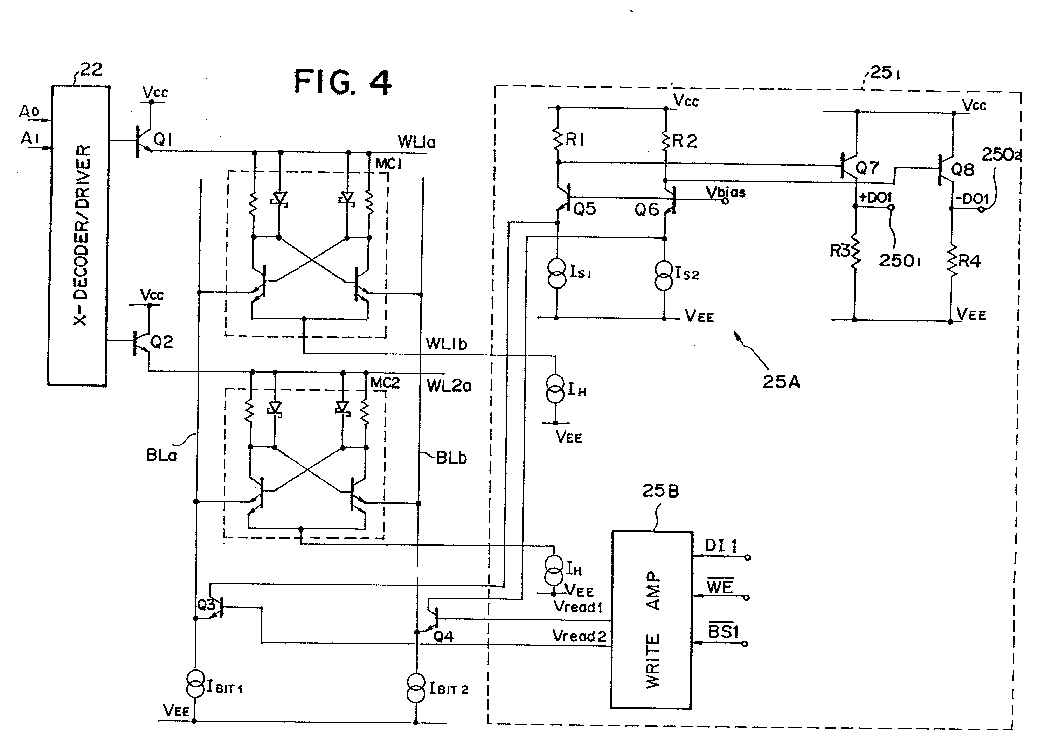

FIG.4 shows an essential part of the embodiment related to the RAM part 20. In FIG.4, the memory cell array 24 includes word lines WL1a, WL1b, WL2a and WL2b, bit lines BLa and BLb, memory cells MC1 and MC2 respectively connected to the bit lines BLa and BLb and the corresponding word lines WL1a and WL1b and WL2a and WL2b, and current sources $I_{BIT1}$ and $I_{BIT2}$ respectively connected to the bit lines BLa and BLb. An output of the X-decoder/driver 22 is coupled to the word line WL1a through a driver transistor Q1 and to the word line WL2a through a driver transistor Q2. An emitter of a transistor Q3 is connected to the bit line BLa in which the current $I_{BIT1}$ flows, and an emitter of a transistor Q4 is connected to the bit line BLb in which the current $I_{BIT2}$ flows. For the sake of convenience, only the circuit construction of the memory cell MC1 is shown in FIG.4.

The sense/write amplifier $25_1$ is made up of a sense amplifier 25A and a write amplifier 25B. The sense amplifier 25A includes transistors Q5 through Q8, resistors R1 through R4, and current sources $I_{S1}$ and $I_{S2}$ which are connected as shown. A bias voltage $V_{bias}$ is supplied to bases of the transistors Q5 and Q6. A node between an emitter of the transistor Q5 and the current source $I_{S1}$ is connected to a collector of the transistor Q3, and a node between an emitter of the transistor Q6 and the current source $I_{S2}$ is connected to a collector of the transistor Q4. The positive phase signal $+DO1$ is output from a terminal $250_1$ while the negative phase signal $-DO1$ is output from a terminal $250_2$. The write amplifier 25B is supplied with the input data $DI1$, the write enable signal $\overline{WE}$, and the control signal $\overline{BS1}$. The write amplifier 25B is enabled or disabled by the control signal $\overline{BS1}$ which is used as a block select signal. The write amplifier 25B outputs signals $V_{read1}$ and $V_{read2}$ based on the input data $DI1$ and the write enable signal $\overline{WE}$, and the signals $V_{read1}$ and $V_{read2}$ are supplied to bases of the corresponding transistors Q3 and Q4.

For example, the memory cell MC1 is selected when the word line WL1a is set to a high level by the X-decoder/driver 22. A current flows through the transistor Q3 or Q4 depending on the state of the memory cell MC1 which is selected in this case. When the current flows through the transistor Q3 and the current does not flow through the transistor Q4, the base level of the transistor Q7 becomes a low level and the transistor Q7 turns OFF while on the other hand the base level of the transistor Q8 becomes a high level and the transistor Q8 turns ON. Hence, the positive phase signal $+DO1$ has a low level and the negative phase signal $-DO1$ has a high level.

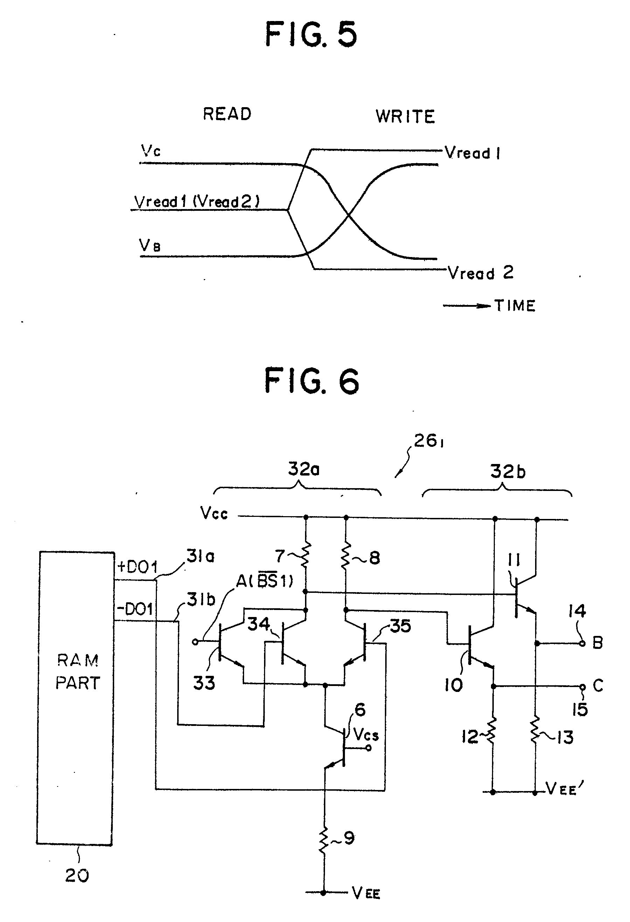

FIG.5 is a timing chart showing the state of the memory cell during the read and write operations. The signals $V_{read1}$ and $V_{read2}$ are set to a read potential shown during the read operation when nodes $V_B$ and $V_C$ of the memory cell MC1 respectively are a low level and a high level as shown. On the other hand, during the write operation, the potential of the signals $V_{read1}$ and $V_{read2}$ is changed depending on whether a data "0" or "1" is to be written into the memory cell MC1.

The amplitude of the positive and negative phase signals $+DO1$ and $-DO1$ is determined by the current sources $I_{S1}$ and $I_{S2}$, the resistors R1 and R2, and the current sources $I_{BIT1}$ and $I_{BIT2}$. The current sources $I_{S1}$ and $I_{S2}$ determine the absolute amplitude of the positive and negative phase signals $+DO1$ and $-DO1$ and the amplitude can be decreased by the setting of the current sources $I_{S1}$ and $I_{S2}$. As will be described later, the amplitude of the positive and negative phase signals $+DO1$ and $-DO1$ is set smaller than the ECL level, that is, the amplitude of the signal output from the ECL gate array part 21.

On the other hand, the ECL gate array part 21 shown in FIG.3 includes ECL circuits $26_1$ through $26_4$ and gates (not shown) which are connected in a stage next to the corresponding ECL circuits $26_1$ through $26_4$. An ECL circuit $26_i$ is supplied with the positive and negative phase signals $+DOi$ and $-DOi$ from the sense amplifier $25_i$ and the control signal

$\overline{BS}i$, where $i = 1, 2, 3$ and 4.

FIG.6 shows another essential part of the embodiment related to the ECL circuit $26_1$. In FIG.6, those parts which are substantially the same as those corresponding parts in FIG.1 are designated by the same reference numerals, and a description thereof will be omitted. In FIG.6, the data output of the RAM part 20, that is, the positive phase signal +DO1 and the negative phase signal -DO1 are supplied to the ECL circuit $26_1$ through respective lines 31a and 31b. The ECL circuit $26_1$ is made up of a differential logic part 32a and an emitter follower output part 32b, and the differential logic part 32a has a construction different from that of the differential logic part 3a shown in FIG.1.

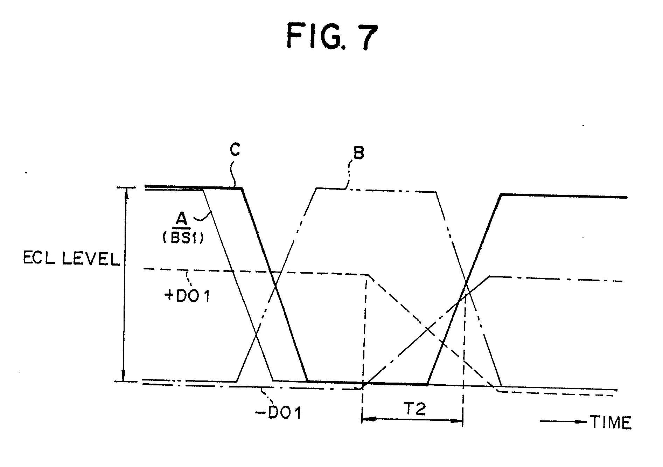

The differential logic part 32a of the ECL circuit $26_1$ includes transistors 33 through 35 for making a differential input, a transistor 36 which is used as a current source, and the resistors 7 through 9. The control signal $\overline{BS}1$ is supplied to a base of the transistor 33, and this control signal $\overline{BS}1$ is indicated as A in FIGS.6 and 7 for the sake of convenience. The negative phase signal -DO1 is supplied to a base of the transistor 34, and a positive phase signal +DO1 is supplied to a base of the transistor 35. The control signal A ($\overline{BS}1$) is a binary signal which varies within a range of -0.9 V to -1.6 V which corresponds to the ECL level referred before. Emitters of the transistors 33 through 35 are connected in common to a collector of the transistor 6. Hence, the differential logic part 32a carries out a predetermined operation responsive to a differential input from the RAM part 20, that is, the positive and negative phase signals +DO1 and -DO1.

Next, a description will be given of an operation of the ECL circuit $26_1$, by referring to FIG.7. The control signal A ($\overline{BS}1$) is used to fix (clamp) the output signals B and C of the ECL circuit $26_1$. When the control signal A has a high level, a signal supplied to the base of the transistor 33 has a level higher than the amplitudes of the positive and negative phase signals +DO1 and -DO1 as shown in FIG.7. Thus, the output signal B is fixed to a high level and the output signal C is fixed to a low level regardless of a change in the differential input with respect to the transistors 34 and 35. Therefore, the necessary operation can be carried out with ease in a state where the data output of the RAM part 20 is held by simply controlling the control signal A.

On the other hand, when the control signal A has a low level, the differential logic part 32a is activated responsive to the data output of the RAM part 20 and the output signals B and C change as shown in FIG.7. In other words, the data output of the RAM part 20 is received as a 2-phase differential input by the ECL circuit $26_1$ when the control signal A has the low level, and the transistors 34 and 35 start switching immediately when a level difference occurs in the differential input of the transistors 34 and 35, unlike the conventional case where the switching starts after crossing the reference voltage $V_{ref}$. Therefore, the switching of the transistors 34 and 35 takes place at a time when the positive phase signal +DO1 and the negative phase signal -DO1 cross in FIG.7, and there is no delay in the switching as in the conventional case. That is, a signal change in the data output of the RAM part 20 is transmitted as it is to the ECL circuit $26_1$ and the switching takes place therein.

As shown in FIG.7, there is a time delay T2 from the beginning of a change in the positive and negative phase signals +DO and -DO output from the RAM part 20 to a change of the output signals B and C of the ECL circuit $26_1$. But this delay time T2 is short compared to the delay time T1 of the conventional case shown in FIG.2. The delay time T2 is short compared to the delay time T1 because the swing of the positive and negative phase signals +DO and -DO is small and the differential logic part 32a of the ECL circuit $26_1$ is driven by a differential drive. The amplitude of the output signals B and C of the ECL circuit $26_1$ is determined by the resistances of the resistors 7 through 9, the current flowing through the transistor 6 and the like.

The ECL circuits $26_2$ through $26_4$ have constructions similar to that of the ECL circuit $26_1$ shown in FIG.5, and illustration and description thereof will be omitted.

In this embodiment, the amplitude of the positive and negative phase signals is approximately one-half the ECL level and small, thereby making it possible to reduce a time required for the switching. As a result, the switching speed can be reduced by approximately 30% to 50% compared to the conventional case shown in FIGS.1 and 2, and the data processing can be carried out at a high speed.

Further, the present invention is not limited to these embodiments, but various variations and modifications may be made without departing from the scope of the present invention.

**Claims**

1. A semiconductor device in a single chip comprising a memory (20) having a plurality of memory cells, and an emitter coupled logic gate array (21) for carrying out a predetermined logic operation on a data output from one of the memory cells of said memory and for outputting an output signal having a first amplitude, characterized in that said memory (20) includes means ($25_1$-$25_4$) for outputting as the data output a positive phase signal (+DO) and a negative phase signal (-DO) respectively having a second amplitude smaller than the first amplitude.

2. The semiconductor device as claimed in claim 1, characterized in that said memory (20) comprises an X-address decoder/driver (22) for decoding and driving a predetermined word line based on first address data in an X-direction, a Y-decoder/driver (23) for decoding and driving a predetermined bit line based on second address data in a Y-direction, a memory cell array (24) of the memory cells for storing data of predetermined bits, and sense/write amplifiers ($25_1$ -$25_4$) for controlling a write operation with respect to the memory cell array based on a write enable signal ($\overline{WE}$) and for reading data from the memory cell array, said output means ($25_1$-$25_4$) of said memory being included in the sense/write amplifiers for outputting the positive phase signal (+DO) and the negative phase signal (-DO) based on the write enable signal and an input data (DI) to said memory, said sense/write amplifiers being supplied with a control signal ($\overline{BS}$) for selecting a block of the memory cell array.

3. The semiconductor device as claimed in claim 1 or 2, characterized in that said memory (20) is a random access memory.

4. The semiconductor device as claimed in any of claims 1 to 3, characterized in that said emitter coupled logic gate array (21) comprises a plurality of emitter coupled logic circuits ($26_1$-$26_4$) for receiving the data output of said memory (20).

5. The semiconductor device as claimed in claim 4, characterized in that each emitter coupled logic circuit ($26_1$-$26_4$) comprises a differential logic part (32a) for carrying out the predetermined logic operation responsive to a differential input and an emitter follower output part (32b) for outputting the output signal of said emitter coupled logic gate array (21) based on an output of said differential logic part, said differential input being the positive phase signal (+DO) and the negative phase signal (-DO) received from said memory (20).

6. The semiconductor device as claimed in claim 5, characterized in that said differential logic part (32a) further receives a control signal ($\overline{BS}$) which is originally used for selecting a block of said memory (20), said control signal having a first level for fixing the output signal of said emitter coupled logic gate array (21) and a second level for permitting a change in level of the output signal of said emitter coupled logic gate array.

7. The semiconductor device as claimed in claim 6, characterized in that said control signal ($\overline{BS}$) has the first amplitude.

8. The semiconductor device as claimed in claim 5, characterized in that said emitter follower output part (32b) outputs complementary signals as the output signal of said emitter coupled logic gate array (21).

9. The semiconductor device as claimed in any of claims 1 to 8, characterized in that said second amplitude is approximately one half said first amplitude.

10. The semiconductor device as claimed in any of claims 1 to 9, characterized in that the positive phase signal and (+DO) the negative phase signal (-DO) respectively vary in a range of approximately -1.2 V to -1.6 V.

11. The semiconductor device as claimed in claim 10, characterized in that the output signal of said emitter coupled logic gate array (21) varies in a range of approximately -0.9 V to -1.6 V.

# FIG. 1
## PRIOR ART

# FIG. 2
## PRIOR ART

# FIG. 3

FIG. 4

# FIG. 5

READ              WRITE

$V_C$

Vread 1 (Vread 2)

$V_B$

Vread 1

Vread 2

→ TIME

# FIG. 6

# FIG. 7